# EUROPÄISCHE PATENTSCHRIFT

(11) **EP 1 735 909 B1**
(45) Veröffentlichungstag und Bekanntmachung des Hinweises auf die Patenterteilung: **19.09.2018**
(21) Anmeldenummer: 05728439.0
(22) Anmeldetag: 01.04.2005
(51) Int. Cl.: H03K 3/537

(54) **MARX-GENERATOR**
MARX GENERATOR
GENERATEUR DE MARX

(30) Priorität: 13.04.2004 DE 102004017875
(43) Veröffentlichungstag der Anmeldung: 27.12.2006
(73) Patentinhaber: Diehl Defence GmbH & Co. KG, 88662 ÜBERLINGEN (DE)
(72) Erfinder: HOFMANN, Helmut, 91322 Gräfenberg (DE)
(74) Vertreter: Diehl Patentabteilung
(86) Internationale Anmeldenummer: PCT/EP2005/003443
(87) Internationale Veröffentlichungsnummer: WO 2005/101659

(56) Entgegenhaltungen:
- FR-A- 2 823 033
- US-A- 6 166 459
- ANONYMOUS: "Marx-Generator" INTERNET ARTICLE, [Online] , - 2003 XP002338639 Gefunden im Internet: URL:http://web.archive.org/web/20030906100 103/http://www.hoelscher-hi.de/hendrik/hv/ marx.htm>

## Beschreibung

Die Erfindung betrifft einen Marx-Generator.

Der 1923 von Herrn Prof. Marx (TU Braunschweig) erfundene Stoßspannungsgenerator dient der Bereitstellung eines Hochspannungsimpulses etwa für Zwecke der Isolationsprüfung, der Untersuchung des Verhaltens von Gasen in starken elektrischen Feldern oder gemäß DE 101 51 565 A1 der Anregung eines Resonators zur Abstrahlung von Mikrowellenenergie hoher Leistung.

Aus dem Internet-Artikel "Marx-Generator" (URL: http://web.archive.org/web/ 20030906100103/http://www.hoelscher-hi.de/hendrik/hv/marx.htm) ist ein Marx-Generator gemäß dem Oberbegriff des Anspruchs 1 bekannt. In diesem Dokument ist unter anderem beschrieben, dass sich als Widerstände außer kommerziellen HV-Hochlast-Typen auch schwarzer Gummischlauch oder Salzwasser mit Nägeln als Elektroden eignen.

Die grundsätzliche Funktion des Marx-Generators beruht darauf, eine Kondensatorbatterie mit einer Anzahl n (i = 1, 2, 3, ..., n) von zueinander parallel geschalteten Kondensatoren auf eine von einer Gleichspannungsquelle über einen elektronischen Spannungswandler gelieferte mäßig hohe Eingangsspannung aufzuladen und dann in Serie zu schalten, so dass über diese Serienschaltung die n-fache Eingangsspannung als Ausgangsspannung verfügbar ist. Dabei erfolgt das Umsteuern von der Parallelschaltung in die Serienschaltung von jeweils zwei in der Kondensatorbatterie aufeinander folgenden Kondensatoren mittels einer Funkenstrecke. Bei Ansprechen einer ersten von ihnen zünden dann auch alle anderen Funkenstrecken in der Kondensatorbatterie praktisch gleichzeitig durch. Das Ansprechen der ersten Funkenstrecke kann mittels deren Ansprechspannung, also über die Querschnittsgeometrie und den gegenseitigen Abstand der Funkenstreckenelektroden vorgegeben werden; oder das Ansprechen der ersten der Funkenstrecken wird durch einen ihr extern zugeführten Triggerimpuls eingeleitet. Entkopplungswiderstände, die auch als die Zeitkonstanten bestimmende Ladewiderstände wirken, verhindern, dass einer der beiden Kondensatoren, zwischen denen die Funkenstrecke zur Serienschaltung liegt, infolge des Durchzündens der Funkenstrecke kurzgeschlossen wird. Dadurch wirkt die Reihenschaltung der Lade- und Entkopplungswiderstände beim Umschalten der Kondensatoren auf Serienschaltung als Hochspannungs-Spannungsteiler. Und deshalb müssen hier hochspannungsfeste Widerstände eingesetzt werden, die allerdings teuer sind und in der Praxis im Zuge einer längeren Folge von Betriebszyklen des Marx-Generators ihre elektrischen Eigenschaften häufig verändern. Das hat zur Folge, dass der Marx-Generator nicht über eine längere Zeitspanne stabil arbeitet, wenn er etwa quasikontinuierlich den erwähnten Mikrowellen-Resonator betreiben soll. Man könnte zwar die Widerstände hinsichtlich ihrer Spannungsfestigkeit überdimensionieren, aber das würde die Kosten noch weiter in die Höhe treiben und dennoch keinen dauerhaft stabilen Betrieb sicherstellen.

Deshalb liegt vorliegender Erfindung die technische Aufgabenstellung zugrunde, mit preisgünstigen Schaltungsmitteln einen hinsichtlich der Hochspannungsbeanspruchung seiner Lade- und Entkopplungswiderstände dauerstandfesten Marx-Generator zu schaffen.

Diese Aufgabe ist erfindungsgemäß durch die im Hauptanspruch angegebene Merkmalskombination gelöst. Danach werden zwischen die einzelnen Kondensatorstufen nun keine diskreten, hochspannungsfesten Widerstände mehr eingelötet. Sondern diese Serienschaltungen von hochspannungsfesten Widerständen werden ersetzt durch ein Formteil aus elektrisch leitendem Kunststoff, wobei unter Kunststoff sowohl herkömmliche Kunststoffe, Harze, Gummi, Elastomere, etc. zu verstehen sind. Ein solches Formteil ist etwa als Thermoplast mit Kohlenstoffeinlagen (Graphitpartikeln), als Silikon mit Einlagen aus versilbertem Kupfer oder als Kunststoff mit darin längsausgerichteten metallischen Fasern handelsüblich und preiswert verfügbar. Solche leitfähigen Polymere zeigen keine Abhängigkeit ihres elektrischen Verhaltens von der Hochspannungsbeanspruchung. Außerdem sind sie als über mehrere Kontaktstellen durchlaufende Materialbrücken, die etwa mit Nieten oder unter Schrauben auf dem Formteil oder durch dieses hindurch auf einer isolierenden Unterlage kontaktiert werden, leichter zu handhaben, als die unter Berücksichtigung von Schutzmaßnahmen gegen Spannungsüberschläge einzeln einzulötenden herkömmlichen Hochspannungswiderstände.

Im Falle des Marx-Generators eröffnet der Austausch der Hochspannungswiderstände gegen wenigstens ein Formteil aus leitfähigem Kunststoff somit die Möglichkeit, jeweils ein durchgehendes Formteil über die beiden Kondensatoranschlüsse zu verlegen, so dass auf jeder Seite des Kondensators nur ein einziges Bauteil für die Widerstands-Serienschaltung zu montieren ist, wobei anstelle eines einzigen auch mehr als ein durchgehendes Formteil vorgesehen sein kann. Je nach der geometrischen Anordnung der Kondensatoren beim mechanischen Aufbau des Marx-Generators kann das jeweilige Formteil aus leitfähigem Kunststoff etwa linear, U-förmig, O-förmig oder in einer komplexen Form, die an die geometrische Anordnung der Kondensatoranschlüsse bzw. der Widerstands-Serienschaltung angepasst ist, ausgebildet sein, so dass für jede geometrische Auslegung stets anstelle der Vielzahl einzulötender Widerstände jeweils nur noch ein einzelnes aufzulegendes Formteil aus leitfähigem Kunststoff erforderlich ist, das mit den jeweiligen Anschlüssen der Kondensatorbatterie etwa über Kontaktschrauben verbunden wird.

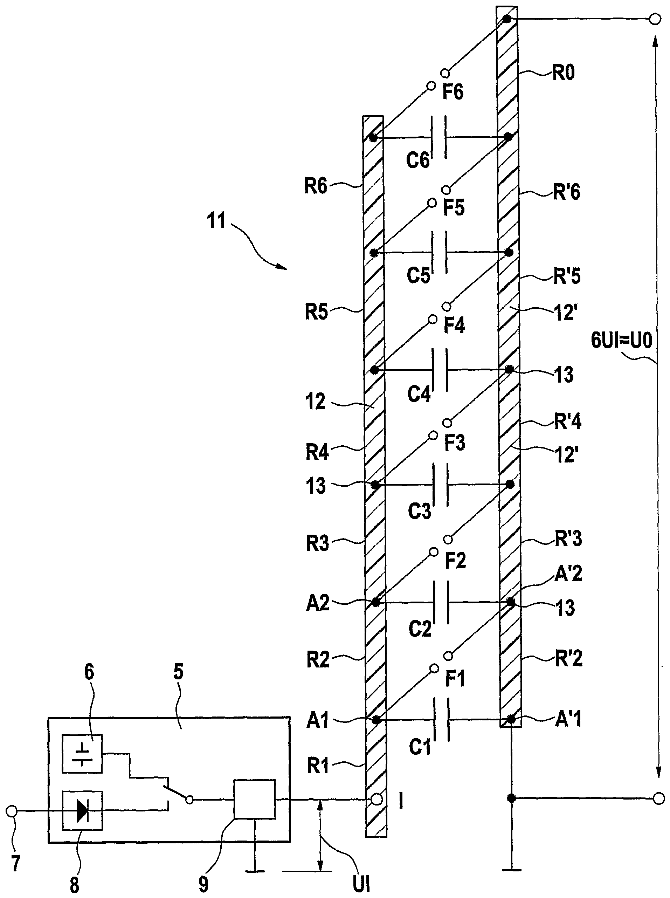

Dies ist in beiliegender Zeichnung näher veranschaulicht, aus deren nachstehender Erläuterung sich, abgesehen von den weiteren Ansprüchen, zusätzliche Merkmale und Weiterbildungen der Erfindung ergeben. Die einzige Figur der Zeichnung zeigt das Prinzipschaltbild eines Marx-Generators in Form der Blockanordnung einer Kondensator-Batterie, deren Kondensatoren parallel aufgeladen und dann über Lichtfunkenstrecken parallelgeschaltet werden.

Der klassische Marx-Generator 11 weist eine Gruppe von n (i = 1, 2, ..., n), hier n = 6, Kondensatoren Ci auf, die zunächst untereinander elektrisch parallel geschaltet sind. Dadurch wird jeder dieser Kondensatoren Ci über seinen Ladewiderstand Ri auf eine Eingangs-Gleichspannung UI aufgeladen, wobei allerdings die Ladewiderstände Ri nach Art eines Spannungsteilers in Serie geschaltet sind. Von einem Kondensator-Anschluss Ai eines Kondensators Ci zum gegenüberliegenden Kondensator-Anschluss A'i+1 des nächst benachbarten Kondensators Ci+1 der Parallelschaltung erstreckt sich eine Funkenstrecke Fi. Wenn diese (aufgrund Spannungsdurchbruches oder infolge externer Initialisierung) durchzündet, wird damit der eine Anschluss Ai des einen Kondensators Ci auf den gegenüberliegenden Anschluss A'i+1 des benachbarten Kondensators Ci+1 geschaltet, so dass sich die Serienschaltung Ci-Ci+1 ergibt. Ein Kurzschluss des Kondensators Ci+1 über die Funkenstrecke Fi findet infolge des Ladewiderstandes Ri+1 nicht statt, während ein Kurzschluss des Kondensators Ci über seine Funkenstrecke Fi durch einen Entkopplungswiderstand R'i+1 verhindert ist. Die Ladekonstante des Kondensators Ci+1 setzt sich also aus der Serienschaltung der Ladewiderstände Ri-Ri+1 und des Entkopplungswiderstandes R'i+1 zusammen. In der Zeichnung ist R'₆₊₁ mit RO bezeichnet.

Die über die Funkenstrecke Fi erfolgende Serienschaltung der beiden auf die Eingangsspannung UI aufgeladenen Kondensatoren Ci und Ci+1 erbringt infolge deren Serienschaltung die Spannung 2xUI, also die zweifache Eingangsspannung. Deshalb schlägt praktisch sofort auch die Funkenstrecke Fi+1 über, und die bisherige Serienschaltung wird um den Spannungsbeitrag des nächstfolgenden Kondensators Ci+2 aufgestockt; und so fort. So steht schließlich am anderen Ende der gesamten Kondensator-Serienschaltung die Ausgangsspannung nxUI = UO an.

Die Eingangsspannung UI wird von einer Spannungsquelle 5 geliefert, bei der es sich um einen Gleichspannungs-Speicher 6 oder um ein Wechselstrom-Netz 7 mit Gleichrichter 8 handeln kann. Zweckmäßiger Weise folgt ein handelsüblicher elektronischer Spannungswandler 9, der die Eingangsspannung UI in der Größenordnung von typisch 10 kV liefert.

Was unter Bezugnahme auf die Schaltungsskizze der Zeichnung zur Funktionserläuterung als nur 6-stufiger Marx-Generator dargestellt ist, wird in der Praxis zum Gewinnen einer entsprechend hohen Ausgangsspannung UO durch entsprechend viele Kondensatoren Ci eine mehrere 10-fache bis über 100-fache Eingangsspannung UI realisiert. Entsprechend viele hochspannungsfeste Widerstände Ri, R'i müssen einerseits zwischen die Anschlüsse Ai-Ai+1 und andererseits zwischen die Anschlüsse A'i-A'i+1 eingelötet werden. Das ist material- und zeitaufwendig.

Im Ausführungsbeispiel der Erfindung wird aus einem leitfähigen Kunststoff, wobei unter Kunststoff sowohl herkömmliche Kunststoffe als auch Harze, Gummi, Elastomere, etc. zu verstehen ist, für jede dieser Widerstandsserienschaltungen Ri, R'i an den beiden Seiten der Kondensatorbatterie als Formteil ein Streifen aus leitfähigem Kunststoff 12 über die geometrischen Anordnungen der Anschlüsse Ai, A'i der Kondensatoren Ci verlegt, die etwa zwischen zwei isolierenden Montageplatten mechanisch gehaltert sind. Die elektrische Kontaktierung zwischen dem jeweiligen Kondensator-Anschluss Ai bzw. A'i und dem Kunststoff-Streifen 12, 12' kann etwa durch Lötpunkte, durch Nieten oder zweckmäßiger Weise durch Kontaktschrauben 13 erfolgen, die durch Kontaktfahnen an den Kondensator-Anschlüssen Ai, A'i hindurch in den Kunststoff-Streifen 12 bzw. 12' hinein oder durch dieses hindurch in die darunter gelegene Montageplatte geschraubt werden. Dabei folgt die Geometrie des Streifens 12, 12' dem Verlauf der Anschlüsse Ai bzw. A'i, so dass anstelle einer Anzahl einzeln handzuhabender Hochspannungswiderstände nun auf jeder Seite der Kondensatorbatterie nur ein einzelner Widerstandsstreifen 12 bzw. 12' einzulegen und kraft- oder formschlüssig unter Kontaktierung an die Kondensator-Anschlüsse Ai, A'i festzulegen ist.

Zusammenfassend ist also festzustellen, dass erfindungsgemäß die funktionskritische Serienschaltung von hochspannungsfesten Widerständen Ri, R'i in einem Marx-Generator 11 durch ein Formteil 12, 12' leitfähigen Kunststoffes ersetzt ist, das je nach der Aufbau-Gruppierung der Kondensatorbatterie über die daraus resultierende geometrische Folge der Kondensator-Anschlüsse Ai, A'i verläuft und mit diesen verbunden, etwa vernietet oder verschraubt ist, wobei anstelle eines einzigen Formteils auch mehr als ein durchgehendes Formteil eingesetzt sein kann.

## Patentansprüche

1. Marx-Generator (11) mit einer Anzahl von n Kondensatoren (C1 bis C6), die in Parallelschaltung über n Ladewiderstände (R1 bis R6) und n Entkopplungswiderstände (R'2 bis R'6, RO) jeweils auf eine Eingangsspannung (UI) aufladbar und dann über n Funkenstrecken (F1 bis F6) einander in Serie schaltbar sind, um als Ausgangsspannung (UO) die n-fache Eingangsspannung (UI) zu liefern,
wobei die Serienschaltung der n Ladewiderstände (R1 bis R6) und der n Entkopplungswiderstände (R'2 bis R'6, RO) jeweils als ein Formteil (12; 12') elektrisch leitfähigen Kunststoffes ausgebildet ist, das mit den jeweils zugeordneten Anschlüssen (A1 bis A6; A'1 bis A'6) der n Kondensatoren (C1 bis C6) verbunden ist,
**dadurch gekennzeichnet,**
**dass** die Anschlüsse (A1 bis A6; A'1 bis A'6) mit dem ihnen jeweils zugeordneten Formteil (12; 12') kraft- oder formschlüssig verbunden sind, und
**dass** die Anschlüsse (A1 bis A6; A'1 bis A'6) durch das jeweilige Formteil (12; 12') hindurch mit einer isolierenden Montageplatte verschraubt sind, die zugleich mechanische Halterung für die Anordnung der Kondensatoren (C1 bis C6) ist.

2. Marx-Generator nach Anspruch 1,
**dadurch gekennzeichnet,**
**dass** die Anschlüsse (A1 bis A6; A'1 bis A'6) mittels Kontaktschrauben (13) mit dem ihnen jeweils zugeordneten Formteil (12; 12') verschraubt sind.

3. Marx-Generator nach einem der vorhergehenden Ansprüche,
**dadurch gekennzeichnet,**
**dass** das Formteil (12; 12') als Streifen ausgebildet ist.

4. Marx-Generator nach einem der vorhergehenden Ansprüche,
**dadurch gekennzeichnet,**
**dass** das Formteil (12; 12') linear, U-förmig oder O-förmig ausgebildet ist.

5. Marx-Generator nach einem der vorhergehenden Ansprüche,
**dadurch gekennzeichnet,**
**dass** die Serienschaltung der Widerstände (R1 bis R6; R'2 bis R'6, RO) durch mehr als ein einziges Formteil ausgebildet ist.

## Claims

1. Marx generator (11) having a number of n capacitors (C1 to C6), which can be charged connected in parallel via n charging resistors (R1 to R6) and n decoupling resistors (R'2 to R'6, RO) in each case to an input voltage (UI), and can then be connected in series with one another via n spark gaps (F1 to F6), in order to produce n-times the input voltage (UI) as the output voltage (UO),
wherein
the series-connected n charging resistors (R1 to R6) and the n decoupling resistors (R'2 to R'6, RO) are each in the form of a molding (12, 12') of electrically conductive plastic, which is connected to the respectively associated connections (A1 to A6; A'1 to A'6) of the n capacitors (C1 to C6),
**characterized**
**in that** the connections (A1 to A6; A'1 to A'6) are connected in a force-fitting or interlocking manner to the molding (12, 12') respectively associated with them, and
**in that** the connections (A1 to A6; A'1 to A'6) are screwed through the respective molding (12, 12') to an insulating mounting panel, which at the same time provides mechanical retention for the arrangement of capacitors (C1 to C6).

2. Marx generator according to Claim 1,
**characterized**
**in that** the connections (A1 to A6; A'1 to A'6) are screwed to the molding (12, 12') respectively associated with them by means of contact screws (13).

3. Marx generator according to one of the preceding claims,
**characterized**
**in that** the molding (12, 12') is in the form of a strip.

4. Marx generator according to one of the preceding claims,
**characterized**
**in that** the molding (12, 12') is linear, U-shaped or O-shaped.

5. Marx generator according to one of the preceding claims,
**characterized**
**in that** the series-connected resistors (R1 to R6; R'2 to R'6, RO) are formed by more than a single molding.

## Revendications

1. Générateur de Marx (11), comprenant un nombre n de condensateurs (C1 à C6) qui, dans un branchement en parallèle, peuvent être chargés par le biais de n résistances de charge (R1 à R6) et n résistances de découplage (R'2 à R'6, RO) respectivement à une tension d'entrée (UI) et peuvent ensuite être branchés en série les uns avec les autres par le biais de n éclateurs (F1 à F6) afin de délivrer une tension de sortie (UO) égale à n fois la tension d'entrée (UI),
le circuit série des n résistances de charge (R1 à R6) et des n résistances de découplage (R'2 à R'6, RO) étant respectivement réalisé sous la forme d'une pièce moulée (12 ; 12') en matière plastique électriquement conductrice qui est reliée aux bornes (A1 à A6 ; A'1 à A'6) respectivement associées des n de condensateurs (C1 à C6),
**caractérisé en ce**
**que** les bornes (A1 à A6 ; A'1 à A'6) sont reliées par assemblage de force ou par complémentarité de formes à la pièce moulée (12 ; 12') qui leur est respectivement associée, et
**que** les bornes (A1 à A6 ; A'1 à A'6) sont fixées par vissage à travers la pièce moulée (12 ; 12') à une plaque de montage isolante qui est en même temps le maintien mécanique pour l'arrangement des condensateurs (C1 à C6).

2. Générateur de Marx selon la revendication 1, **caractérisé en ce que** les bornes (A1 à A6 ; A'1 à A'6) sont fixées par vissage au moyen de vis de contact (13) à la pièce moulée (12 ; 12') qui leur est respectivement associée.

3. Générateur de Marx selon l'une des revendications précédentes, **caractérisé en ce que** la pièce moulée (12 ; 12') est réalisée sous la forme d'une bande.

4. Générateur de Marx selon l'une des revendications précédentes, **caractérisé en ce que** la pièce moulée (12 ; 12') est de configuration linéaire, en forme de U ou en forme de O.

5. Générateur de Marx selon l'une des revendications précédentes, **caractérisé en ce que** le circuit série des résistances (R1 à R6 ; R'2 à R'6, RO) est formé par plus qu'une seule pièce moulée.
